Europäisches Patentamt

European Patent Office

Office européen des brevets

(11) Publication number: **0 225 333**
**B1**

(12) **EUROPEAN PATENT SPECIFICATION**

(45) Date of publication of patent specification: **23.05.90**

(51) Int. Cl.⁵: **H 01 L 21/48, H 01 L 23/48**

(21) Application number: **86902254.1**

(22) Date of filing: **31.03.86**

(86) International application number:
**PCT/US86/00650**

(87) International publication number:
**WO 86/06212 23.10.86 Gazette 86/23**

(54) **MINI CHIP CARRIER SLOTTED ARRAY.**

(30) Priority: **12.04.85 US 722644**

(43) Date of publication of application:
**16.06.87 Bulletin 87/25**

(45) Publication of the grant of the patent:
**23.05.90 Bulletin 90/21**

(84) Designated Contracting States:
**DE FR GB IT SE**

(56) References cited:
**EP-A-0 057 253**
**EP-A-0 113 282**
**EP-A-0 149 923**
**DE-A-2 447 284**
**GB-A-2 115 607**

(73) Proprietor: **Hughes Aircraft Company**
**7200 Hughes Terrace P.O.Box 45066**
**Los Angeles California 90045-0066 (US)**

(72) Inventor: **ROOT, Randolph, E.**
**15832 Monroe Street**
**Westminster, CA 92683 (US)**

(74) Representative: **Colgan, Stephen James et al**
**CARPMAELS & RANSFORD 43 Bloomsbury**
**Square**
**London WC1A 2RA (GB)**

Courier Press, Leamington Spa, England.

## Description

### Background of the Invention

The disclosed invention generally relates to mini chip carrier arrays, and is particularly directed to a mini chip carrier array wherein individual chip carriers are separated by elongated slots each of which accommodate a plurality of wrap-around edge interconnects for each adjacent chip carrier.

Integrated circuit chips utilized in complex hybrid circuits are often mounted on individual ceramic carriers. Typically, the ceramic carrier is bonded to the hybrid circuit motherboard by soldering the edge interconnects of the ceramic carrier to corresponding conductors on the motherboard.

Ceramic carriers are typically fabricated in unitary arrays wherein each chip carrier array includes a matrix of interconnected chip carriers. Each chip carrier includes a plurality of metallized wrap-around edge interconnects which pass through holes or slits formed along the boundaries between the individual chip carriers and along the chip carrier edges adjacent the substrate waste edge. In some arrays, each hole or slit between adjacent chip carriers accommodates two wrap-around edge interconnects, one from each adjacent chip carrier, while each hole or slit adjacent the substrate waste edge accommodates a single wrap-around edge interconnect for the adjacent chip carrier. In other arrays, a separate hole or slit is provided for each wrap around interconnect.

Typically, the wrap-around edge interconnects are applied by silk screen printing and vacuum pull-through techniques. For arrays having holes or slits between adjacent carriers for accommodating two edge interconnects, the edge interconnects are applied by shared metallization. However, in order to maintain electrical isolation between edge interconnects sharing the same hole or slit, the size of the hole or slit has to be sufficiently large to avoid a short circuit in the metallization process. Thus, the minimum spacing between edge interconnects of an individual chip carrier is limited by a minimum hole or slit size and the necessary spacing between adjacent holes or slits. Such limitation in turn limits the minimum chip carrier size.

The electrical isolation referred to above allows for electrical testing of the entire chip carrier array prior to separation of the array into individual chip carriers. Of course, if such testing is not necessary, then smaller holes or slits could be tolerated to achieve closer spacing of the edge interconnects. However, separation of the array into individual chip carriers could cause damage to the chip carriers having short circuited edge interconnects.

The arrays wherein each edge interconnect has its own hole or slit allows for closer spacing, but the minimum spacing is still limited since metallization within a hole or slit becomes more difficult as its size decreases. Moreover, the production of such a chip carrier array is more complex and expensive.

A further disadvantage of known chip carrier arrays is that corners of individual chip carriers randomly break when the array is separated into individual chip carriers. Such breaking typically damages edge interconnects, thereby rendering useless each chip carrier having a damaged conductor. To the extent that integrated circuit chips are mounted on the chip carriers prior to separation of the chip carrier array, a damaged chip carrier also results in a wasted integrated circuit.

Another disadvantage of known chip carrier arrays is the high cost of production resulting from (1) the necessary laser fabrication of numerous through holes or slits, (2) the difficulty of inspecting individual chip carriers, and/ or (3) the reduced yield caused by breakage.

According to the present invention there is provided a chip carrier array comprising:

a planar insulating substrate; and

a plurality of individual chip carriers formed in said substrate and having outer edges defined by elongated slots which extend from a plurality of severable support bridges located along the sides of each of said chip carriers, which bridges maintain the individual chip carriers within the array, each of said chip carriers being provided with metallized edge interconnects which wrap around edges defined by said elongated slots;

characterised in that each chip carrier is provided with corners which are defined by said elongated slots.

A chip carrier array in accordance with the precharacterising clause of the last paragraph is known from GB-A-2 115 607.

According to a further aspect of the invention there is provided a method of making a chip carrier array comprising:

providing a planar insulating substrate;

forming elongated slots in said substrate to extend from severable support bridges whereby said slots and bridges define the edges of individual chip carriers; and

providing metallized edge interconnects which wrap around edges defined by said elongated slots;

characterised in that said step of forming comprises providing corners for each individual chip carrier which are defined by said elongated slots.

### Brief Description of the Drawings

The advantages and features of the disclosed invention will readily be appreciated by persons skilled in the art from the following detailed description when read in conjunction with the drawing wherein:

FIGURE 1 is a perspective view of a section of a chip carrier array made in accordance with the invention.

FIGURE 2 is a detailed partial perspective view of four adjacent chip carriers of the chip carrier array section of Figure 1.

FIGURE 3 is a cross-sectional view through an edge interconnect of the chip carrier of the invention.

FIGURE 5 is a top plan view illustrating the shared metallization for making the edge interconnects of the chip carrier of the invention.

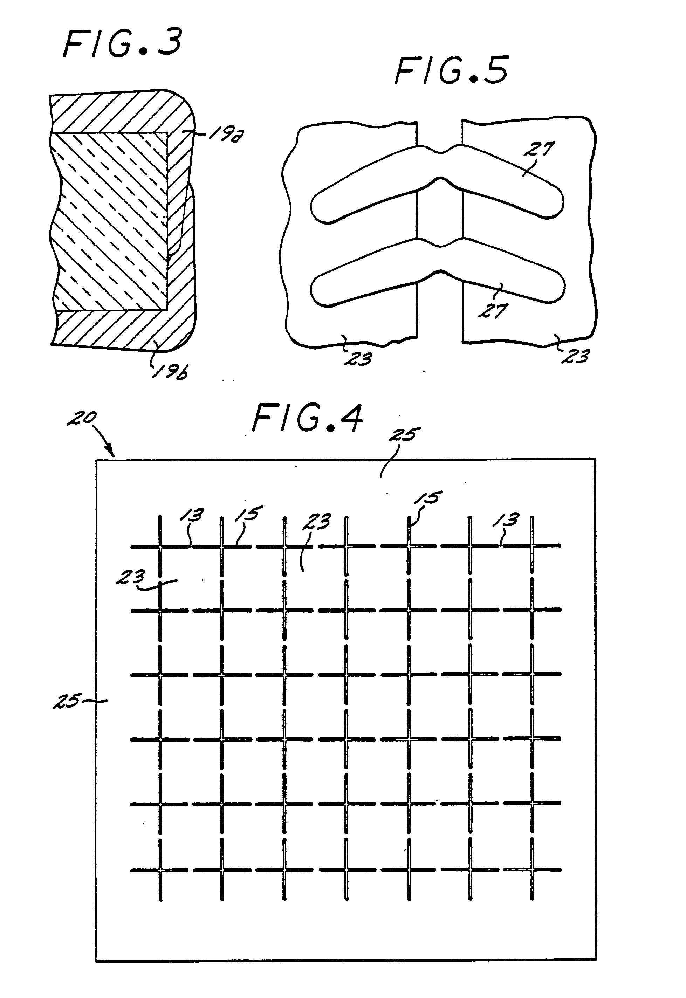

FIGURE 4 is a schematic top plan view of the substrate of the chip carrier array of the invention.

Detailed Description

In the following detailed description and in the several figures of the drawing, like elements are identified with like reference numerals.

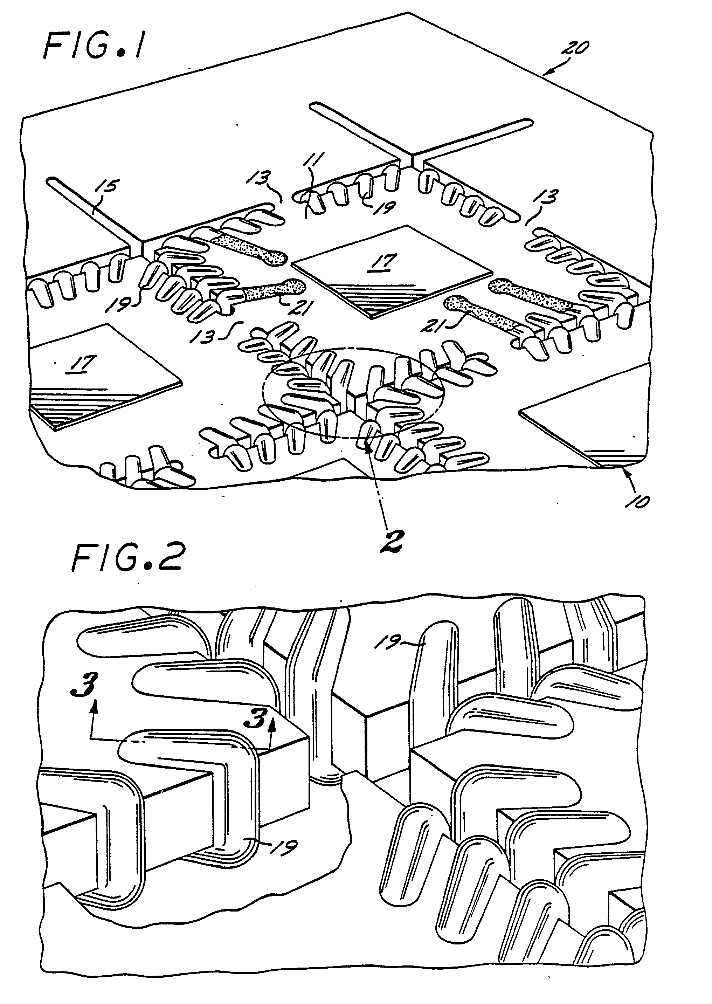

Referring now to Figure 1, shown therein is a perspective view of a section of the chip carrier array 10 of the invention which is formed on a ceramic substrate 20. The chip carrier array 10 includes a plurality of chip carriers 11 which are interconnected to each other and to the substrate waste edge (shown in Figure 4) by a plurality of support bridges 13. The chip carriers 11 are separated from each other and from the substrate waste edge by elongated slots 15 which extend from the support bridges 13 beyond each corner of an adjacent chip carrier 11.

Each chip carrier 11 includes a centrally located die pad 17 for accepting an integrated circuit chip (not shown). As is well known, the die pad 17 is a conductive region which may be formed by thick film metallization. Each chip carrier 11 further includes a plurality of metallized edge interconnects 19 which wrap around the edges defined by the elongated slots 15. As particularly shown in Figures 2 and 3, each edge interconnect 19 extends slightly on the top and bottom surfaces of its associated chip carrier 11. By way of example, the edge interconnects 19 are metallized by silk screen printing and vacuum pull through chniques.

A metallized wire bond interconnect 21 is conductively attached to each edge interconnect 19. For ease of reference, only a few wire bond interconnects 21 are shown. As is well known, an integrated circuit chip is mounted to each chip carrier 11 over the die pad 17. Wire bond connections (not shown) are then made between the integrated circuit leads and the wire bond interconnects 21.

The structure of the elongated slots 15 are more readily understood with reference to Figure 4 which schematically shows the substrate 20 on which the chip carrier array 10 is formed. The ceramic substrate 20 includes chip carrier regions 23 which provide the substrates for the individual chip carriers 11. The chip carrier regions 23 are interconnected by the support bridges 13. Particularly, each side of each chip carrier region 23 is connected to another chip carrier region 23 or to a waste edge 25 by a support bridge 13 which is centrally located on such side.

The individual chip carrier regions 23 are separated from each other or from the waste edge 25 by the elongated slots 15 which extend from the support bridges 13. The elongated slots 15 extend beyond the corners of the chip carrier regions 23, which facilitates separation of the individual chip carriers 11. Thus, each elongated slot 15 intersects another elongated slot 15, and each such intersection defines a corner of one or more chip carrier regions 23.

The foregoing described chip carrier array 10 can be fabricated as follows. The planar ceramic substrate 20 is provided in an appropriate size. The chip carrier regions 23 are defined by forming the elongated slots 15 by laser cutting or other suitable process, thereby leaving the support bridges 13 so that the chip carrier regions 23 remain interconnected.

The edge interconnects 19 are then metallized. By way of example and with reference to Figure 3, each edge interconnect 19 is formed by metallizing a top conductor 19a to wrap around from the top surface of a chip carrier 11 to part way down the side of the chip carrier 11. A bottom conductor 19b is then metallized to wrap around from the bottom surface to overlap the top conductor along the side of the chip carrier 11.

Specifically, the top conductor portions 19a for all the chip carriers 11 of the chip carrier array 10 are applied by shared metallization wherein each pair of opposite top conductor portions 19a of adjacent chip carrier regions 23 are silk screen printed as single strips of metallization paste, as shown by the continuous metallization strips 27 in Figure 5. Application of a vacuum to the bottom of the elongated slots 15 breaks each metallization strip 27 and causes the metallization paste to wrap around the edges of the chip carrier. The top conductor portions 19a so applied are then dried and sintered.

The bottom conductor portions 19b can also be formed by the above-described shared metallization process. The amount of overlap between the top conductor portions 19a and 19b is controlled by the shape of the silk screened metallization strips 27, the constituents of the conductive paste, and the viscosity of the conductive paste.

The wire bond interconnects 21 are metallized by silk screen printing, drying and sintering. As mentioned previously, the die pad 17 may be applied by known thick film metallization techniques.

After the foregoing metallization procedures, integrated circuit chips are mounted over the die pads 17, and wire bond connections are made between the integrated circuit leads and the wire bond interconnects 21.

The chip carriers 11 are then separated from the array 10 by breaking the support bridges 13.

The foregoing described chip carrier array 10 provides significant advantages. As mentioned previously, the use of the elongated slots 15 to define the corners of the chip carriers 11 allows for easy and reliable separation.

The edge interconnects 19 can be formed using shared metallization and can be very closely spaced while maintaining electrical isolation between edge interconnects 19 of adjacent chip

carriers II. By way of example, 20 mil center to center spacing of the edge interconnects 19 has been achieved while maintaining electrical isolation. With known chip carrier arrays, electrical isolation could only be achieved by using larger holes or slits, which prevented close spacing of the edge interconnects.

The above described electrical isolation allows for testing of the chip carrier array 10 with mounted integrated circuit chips prior to separation of the array 10 into individual chip carriers 11. For example, a plurality of probes could be pressed into contact with the wrap around edge interconnects 19 on the bottom side of each chip carrier 11.

In addition to the above-described advantages of easy separation, shared metallization, and closer spacing of conductors, further advantages of the disclosed chip carrier array 10 include lower cost of production and less complexity in production. Further, the disclosed chip carrier array 10 is easier to inspect for defects.

A further feature of the disclosed invention is the chip carrier array substrate structure of Figure 4 which may be readily provided as a product for use in making completed chip carriers.

## Claims

1. A chip carrier array comprising:
   a planar insulating substrate (20); and
   a plurality of individual chip carriers (11) formed in said substrate and having outer edges defined by elongated slots (15) which extend from a plurality of severable support bridges (13) located along the sides of each of said chip carriers, which bridges maintain the individual chip carriers within the array, each of said chip carriers being provided with metallized edge interconnects (19) which wrap around edges defined by said elongated slots;
   characterised in that each chip carrier is provided with corners which are defined by said elongated slots.

2. An array according to claim 1 wherein said insulating substrate (20) is ceramic.

3. An array according to claim 1 or 2 wherein the support bridges (13) are centrally located along the sides of each of said chip carriers (11).

4. An array according to any of claims 1 to 3 wherein each of said chip carriers (11) includes a metallized die pad (17) disposed on one surface thereof for receiving an integrated circuit chip.

5. An array according to claim 4 wherein each die pad (17) comprises a thick film material.

6. An array according to any of claims 1 to 5 wherein said chip carriers (11) further comprise wire bond interconnects (21) on at least one surface thereof and connected to said metallized edge interconnects (19).

7. An array according to any of claims 1 to 6 wherein said metallized edge interconnects (19) extend from the top surfaces of the chip carriers (11) around the edges formed by said elongated slots (15) to the bottom surfaces of the chip carriers (11).

8. An array according to claim 7 wherein said metallized edge interconnects (19) each comprise a first metallization (19a) which extends from one of the surfaces of the chip carriers (11) and wraps around an edge of the elongated slots (15) and extends into said slots, and a second metallization (19b) which extends from the other of the surfaces of the chip carriers (11) and wraps around another edge of the elongated slots (15) to overlap the first metallization and form a continuous edge metallization thereacross.

9. A method of making a chip carrier array comprising:
   providing a planar insulating substrate (20);
   forming elongated slots (15) in said substrate to extend from severable support bridges (13) whereby said slots and bridges define the edges of individual chip carriers (11); and
   providing metallized edge interconnects (19) which wrap around edges defined by said elongated slots;
   characterised in that said step of forming comprises providing corners for each individual chip carrier (11) which are defined by said elongated slots (15).

10. A method according to claim 9 which comprises forming said support bridges (13) centrally along each edge of said chip carriers (11), each corner of each chip carrier (11) being defined by a pair of intersecting slots (15) disposed perpendicular to one another.

11. A method according to claim 9 or 10 wherein said step of providing said metallized edge interconnects (19) comprises:
   (a) applying first pliable unitary conductors (27) to the first surfaces of adjacent chip carriers (11) adjacent to and extending across said elongated slots (15);
   (b) applying a vacuum to pull the first unitary conductors into two first electrically isolated conductors (19a) which wrap part way around the edges of said adjacent chip carriers;
   (c) repeating steps (a) and (b) with second pliable unitary conductors (27) to the second surfaces of adjacent chip carriers so that two further electrically isolated conductors (19b) are provided which wrap part way around the edges of said adjacent chip carriers and electrically contact ones of said first conductors (19a).

## Patentansprüche

1. Eine Chipträgermatrix mit
   einem ebenen isolierenden Substrat (20); und
   einer Mehrzahl von einzelnen Chipträgern (11), welche in dem Substrat gebildet sind und äußere Ränder aufweisen, definiert durch ausgedehnte Schlitze (15), welche sich von einer Mehrzahl von trennbaren Stützbrücken (13) erstrecken, die entlang der Seiten eines jeden der Chipträger gelegen sind, deren Brücken die einzelnen Chipträger innerhalb der Matrix halten, wobei jeder der Chipträger versehen ist mit metallisierten Randverbindungen (19), welche die Ränder umhüllen, welche durch die ausgedehnten Schlitze definiert sind; dadurch gekennzeichnet, daß

jeder Chipträger versehen ist mit Ecken, welche durch die ausgedehnten Schlitze definiert sind.

2. Die Matrix nach Anspruch 1, worin das isolierende Substrat (20) Keramik ist.

3. Die Matrix nach den Ansprüchen 1 oder 2, worin die Stützbrücken (13) zentral entlang den Seiten jeder der Chipträger (11) gelegen sind.

4. Die Matrix nach einem der Ansprüche 1 bis 3, worin jeder der Chipträger (11) eine metallisierte Chipkontaktstelle (17) aufweist, welche angeordnet ist auf einer Oberfläche davon zum Empfang eines integrierten Schaltkreis-Chips.

5. Die Matrix nach Anspruch 4, worin jede Chipkontaktstelle (17) ein Dickschichtmaterial aufweist.

6. Die Matrix nach einem der Ansprüche 1 bis 5, worin die Chipträger (11) des weiteren Drahtbondenverbindungen (21) aufweisen auf mindestens einer Oberfläche davon, und welche an die metallisierten Randverbindungen (19) angeschlossen sind.

7. Die Matrix nach einem der Ansprüche 1 bis 6, worin sich die metallisierten Randverbindungen (19) von den oberen Oberflächen der Chipträger (11) um die Ränder erstrecken, welche durch die ausgedehnten Schlitze (15) gebildet sind, nach den unteren Oberflächen der Chipträger (11).

8. Die Matrix nach Anspruch 7, worin jede der Randverbindungen (19) eine erste Metallisierung (19a) aufweist, welche sich von einer der Oberflächen der Chipträger (11) erstreckt und einen Rand der ausgedehnten Schlitze (15) umhüllt und sich in die Schlitze erstreckt, und eine zweite Metallisierung (19b), welche sich von der anderen der Oberflächen der Chipträger (11) erstreckt und einen anderen Rand des ausgedehnten Schlitzes (15) umhüllt, um die erste Metallisierung zu überlappen und eine kontinuierliche Randmetallisierung darüber zu bilden.

9. Eine Methode zum Erzeugen einer Chipträgermatrix, welche die Schritte aufweist:

Bereitstellen eines planaren isolierenden Substrats (20);

Bilden von ausgedehnten Schlitzen (15) in dem Substrat, um sich von trennbaren Stützbrücken (13) zu erstrecken, wodurch die Schlitze und Brücken die Ränder der eizelnen Chipträger (11) definieren; und

Bereitstellen von metallisierten Randverbindungen (19), welche die Ränder umhüllen, die durch die ausgedehnten Schlitze definiert sind; dadurch gekennzeichnet, daß

der Schritt des Bildens das Bereitstellen von Ecken für jeden der einzelnen Chipträger (11) vorsieht, welche durch die ausgedehnten Schlitze (15) definiert sind.

10. Die Methode nach Anspruch 9, welche das Bilden der Stützbrücken (13) zentral entlang jeden Randes der Chipträger (11) beinhaltet, wobei jede Ecke der Chipträger (11) definiert ist durch ein paar sich kreuzender Schlitze (15), welche senkrecht zueinander angeordnet sind.

11. Die Methode nach den Ansprüchen 9 oder 10, worin der Schritt des Bereitstellens der metallisierten Randverbindungen (19) aufweist:

(a) Aufbringen von ersten biegsamen einheitlichen Leitern (27) auf die ersten Oberflächen von benachbarten Chipträgern (11), welche benachbart sind und sich über die ausgedehnten Schlitze (15) erstrecken;

(b) Aufbringen eines Vakuums, um die ersten einheitlichen Leiter in zwei erste elektrisch isolierte Leiter (19a) zu ziehen, welche Teilwege um die Ränder der benachbarten Chipträger umhüllen;

(c) Wiederholen der Schritte (a) und (b) mit zweiten biegsamen einheitlichen Leitern (27) auf die zweiten Oberflächen der benachbarten Chipträger, so daß zwei weitere elektrisch isolierte Leiter (19b) bereitgestellt werden, welche Teilwege um die Ränder der benachbarten Chipträger umhüllen und diejenigen der ersten Leiter (19a) elektrisch kontaktieren.

**Revendications**

1. Matrice de supports de puces comprenant un substrat isolant plan (20), et un certain nombre de supports de puces individuels (11) formés dans ledit substrat et ayant des bords extérieurs définis par des fentes allongées (15) qui s'étendent entre un certain nombre de ponts de soutien détachables (13) situés le long des côtés de chacun desdits supports de puces, ces ponts maintenant les supports de puces individuels dans la matrice, chacun desdits supports de puces étant muni d'interconnecteurs latéraux métallisés (19) qui s'enroulent autour des bords définis par lesdites fentes allongées; caractérisée en ce que chaque support de puce comporte des coins qui sont définis par lesdites fentes allongées.

2. Matrice conforme à la revendication 1 dans laquelle ledit substrat isolant (20) est en céramique.

3. Matrice conforme à la revendication 1 ou 2 dans laquelle les ponts de soutien (13) sont situés au centre sur les côtés de chacun desdits supports de puces (11).

4. Matrice conforme à l'une des revendications 1 à 3 dans laquelle chacun desdits supports de puces (11) comprend un plot moulé métallisé (17) placé sur l'une de ses surfaces pour recevoir une puce à circuit intégré.

5. Matrice conforme à la revendication 4 dans laquelle chaque plot moulé (17) comprend un matériau en couche épaisse.

6. Matrice conforme à l'une des revendications 1 à 5 dans laquelle lesdits supports de puces (11) comprennent, de plus, des interconnecteurs de raccordement de fils (21) sur au moins l'une des surfaces et reliés auxdits interconnecteurs latéraux métallisés (19).

7. Matrice conforme à l'une des revendications 1 à 6 dans laquelle lesdits interconnecteurs latéraux métallisés (19) s'étendent depuis les surfaces supérieures des supports de puces (11), autour des bords formés par lesdites fentes allongées (15), jusqu'aux surfaces inférieures des supports de puces (11).

8. Matrice conforme à la revendication 7 dans laquelle lesdits interconnecteurs latéraux (19) comprennent chacun une première métallisation (19a) qui s'étend sur l'une des surfaces des supports de puces (11) et s'enroule autour d'un bord des fentes allongées (15) et s'étend dans lesdites fentes, et une seconde métallisation (19b) qui s'étend sur l'autre des surfaces des supports de puces (11) et s'enroule autour d'un autre bord des fentes allongées (15) jusqu'à recouvrir la première métallisation et former un bord de métallisation continue à cet endroit.

9. Méthode de fabrication d'une matrice de supports de puces comprenant:

la production d'un substrat isolant plan (20);

la formation de fentes allongées (15) dans ledit substrat qui s'étendent entre des ponts de soutien détachables (13) par laquelle lesdites fentes et lesdits raccords définissent les bords des supports de puces individuels (11); et

la production d'interconnecteurs latéraux métallisés (19) qui s'enroulent autour des bords définis par lesdites fentes allongées; caractérisée en ce que ladite étape de formation comprend la création de coins pour chaque support de puce individuel (11) qui sont définis par lesdites fentes allongées (15).

10. Méthode conforme à la revendication 9 qui comprend la formation desdits raccords de soutien (13) au centre sur chaque côté desdits supports de puces (11) qui sont définis par le croisement de deux fentes (15) disposées perpendiculairement l'une à l'autre.

11. Méthode conforme à la revendication 9 ou 10 dans laquelle ladite étape de production desdits interconnecteurs latéraux métallisés comprend:

(a) d'abord une application de conducteurs élémentaires modelables (27) sur les premières surfaces de supports de puces adjacents (11) et traversant lesdites fentes allongées (15);

(b) une aspiration pour tirer et séparer ces conducteurs élémentaires en deux premiers conducteurs (19a) isolés électriquement qui s'enroulent en partie autour des tranches desdits supports de puces adjacents;

(c) une répétition des étapes (a) et (b) avec d'autres conducteurs élémentaires modelables (27) sur les secondes surfaces des supports de puces adjacents de sorte que deux conducteurs supplémentaires (19b) isolés électriquement sont réalisés et s'enroulent en partie autour des tranches desdits supports de puces adjacents et forment un contact électrique avec lesdits premiers conducteurs (19a).

*FIG.1*

20

15

13

11

19

13

19

17

21

13

17

21

10

*2*

*FIG.2*

19

3

3

3

19

## FIG.3

## FIG.5

*19a*

*19b*

*27*

*27*

*23*

*23*

## FIG.4

*20*

*25*

*13* *15* *23* *15* *13*

*23*

*25*